# EUROPEAN PATENT SPECIFICATION

(11) **EP 4 379 749 B1**
(45) Date of publication and mention of the grant of the patent: **29.04.2026**
(21) Application number: 22848297.2
(22) Date of filing: 15.07.2022
(51) Int. Cl.: H01B 13/00, H05K 1/03, H05K 1/11, H05K 3/00, H05K 3/12, H05K 3/46, H01B 7/00, H05K 1/09, H05K 1/02, H05K 3/24, H05K 3/28

(54) **WIRING HARNESS PRODUCTION METHOD AND WIRING HARNESS**
KABELBAUMHERSTELLUNGSVERFAHREN UND KABELBAUM
PROCÉDÉ DE PRODUCTION DE FAISCEAU DE CÂBLES ET FAISCEAU DE CÂBLES

(30) Priority: 30.07.2021 CN 202110875932
(43) Date of publication of application: 05.06.2024
(73) Proprietor: Changchun Jetty Automotive Technology Co., Ltd., Changchun City, Jilin Province 130000 (CN)
(72) Inventor: WANG, Chao, Changchun, Jilin 130000 (CN)
(74) Representative: Habermann, Hruschka & Schnabel
(86) International application number: PCT/CN2022/105977
(87) International publication number: WO 2023/005692

(56) References cited:
- WO-A1-92/20489
- WO-A1-92/20489
- CN-A- 1 535 106
- CN-A- 107 846 790
- CN-A- 113 593 776
- KR-A- 20160 000 621
- US-A1- 2006 254 051
- US-A1- 2017 223 827
- US-A1- 2020 389 980

## Description

### RELATED APPLICATION

The present disclosure claims priority of the Chinese invention patent application with an application number of CN202110875932.0, an invention title of 'wiring harness production method and wiring harness' and filed on July 30, 2021.

### TECHNICAL FIELD

The present disclosure relates to the technical field of electronic components, and particularly to a wiring harness production method and a wiring harness.

### BACKGROUND

The electrical connections of transportation vehicles, household appliances, etc. need to be realized by wiring harness. The existing wiring harness is mainly composed of parts such as electrical wires, terminals, sheaths, positioning pieces and brackets, etc. The parts are numerous, the structure is complex, the processing technology is complicated, and the automation degree is low.

A Printed Circuit Board (PCB) can rapidly realize the formation of a dense electrical loop. But the PCB is suitable for an integrated circuit, rather than the electrical connection of an electrical device, and particularly is not suitable for the electrical connection of a large-scale device. The cost of the production device of the PCB is high, and the production process is complex. The production process of the PCB includes etching, which will cause great pollution to the environment.

Patent application KR1020160000621A discloses a FFC cable manufacturing apparatus using the printing method including a first feeding unit for feeding a base insulating film having a conductor printed on an upper surface by a printing facility along a feeding path, a second feeding unit for feeding an upper insulating film having an adhesive applied to an upper surface of the base insulating film along a feeding path, and a punching unit installed on an upper surface of the upper insulating film which is moved along the feeding path, a punching unit for punching a portion of the upper insulating film to form a terminal hole, and a pressing unit for heating and pressurizing the base insulating film and the upper insulating film while moving the base insulating film along the conveying path by rotation, so that conductors printed on the base insulating film are exposed to the outside through the terminal hole.

Patent application US2020389980A1 discloses a flexible circuit board including a substrate with a first side and an opposing second side. The substrate is of a colorless polyimide; first and second circuit patterns formed by deposition of ink on the first and second sides, respectively; at least one opening to interconnect the first and second circuit patterns; and first and second cover layers applied on the first and second circuit patterns, respectively.

### SUMMARY

An objective of the present disclosure is to provide a wiring harness production method and a wiring harness, so as to solve the technical problems of complex production process and high processing cost of a wiring harness for electrically connecting electrical components. The present invention is set out in the appended set of claims. Any references to inventions or embodiments not falling within the scope of the independent claims are to be interpreted as examples useful for understanding the invention.

The above objective of the present disclosure can be achieved by the following technical solutions.

The present disclosure provides a wiring harness production method, including: Step S10: preparing a printing plate; Step S20: preparing a substrate; Step S30: printing conductive ink onto the substrate by the printing plate; Step S40: coagulating the conductive ink to form a conductive trace; and Step S50: forming an insulating protective layer around the conductive trace and on a surface thereof.

The present disclosure provides a wiring harness, which is produced by the wiring harness production method aforementioned, the wiring harness including: a substrate, at least one conductive trace and at least one insulating protective layer, in which each conductive trace is located between the substrate and an outermost insulating protective layer, and the conductive trace and the insulating protective layer are alternately distributed.

The present disclosure has the following characteristics and advantages:

The wiring harness production method employs the mode of conductive ink printing to form a conductive trace on the substrate, in which the conductive trace may be connected to an external electrical component to realize the electrical connection function of the wiring harness; and performs an insulating protection by an insulating protective layer, thereby realizing the rapid formation of a wiring harness loop. The wiring harness production method has the following advantages:
(1) The conductive trace has a high formation efficiency and can be formed at one time, thereby realizing automatic and large-batch rapid production with a high degree of production automation.
(2) The printing plate is prepared in advance and printing is adopted to form a multi-circuit and complex electrical loop.
(3) The wiring harness composed of the parts such as electrical wires, terminals, sheaths, etc., is difficult to be mounted and assembled in the use environment, which is a significant time-consuming step in the whole mounting and assembly process of the product. It is convenient to mount and dismount the wiring harness produced by this production method.
(4) Multi-layer printing is adopted to prepare more conductive traces under the condition of a small area of the substrate, thereby meeting the demand for more electrical loops.
(5) By punching a hole and pouring a conductive material, it is possible to electrically connect the conductive traces of different layers, and realize the design scheme of a complex electrical loop, which is suitable for to more complex wiring harnesses.
(6) The material selection for the insulating protective layer is diverse, and an insulation protection can be realized by adopting a plurality of process modes to ensure the insulation protection effect.
(7) The substrate may be a constituent part of an electrical components, and can realize an integrated production of the components and the wiring harness, thereby achieving the rapid mounting and dismounting of the wiring harness.
(8) A profile modeling printing plate may be adopted and printing may be performed on a non-flat substrate, thereby extending the application environment of the wiring harness.
(9) A flexible substrate may be adopted, so that the wiring harness can be suitable for various mounting situations and convenient to be applied to electrical components in complex mounting environments, which also allows the use in environments with high vibration requirements and reduces the interference of vibration factors.
(10) When the wiring harness is damaged, the damaged substrate can be directly replaced without dismantling and replacing the whole wiring harness, which not only saves maintenance man-hours but also reduces the maintenance cost.
(11) The conductive ink may be prepared using metallic powder or other conductive powder to realize good conductivity, and to make the process of preparing conductive ink simple and convenient preparation and little pollution.
(12) A shielding structure is provided outside the wiring harness, so that a signal in the wiring harness can be shielded from electromagnetic interference at a position with strong electromagnetic interference, thereby ensuring the stability of the signal.
(13) Heat sinks are provided on the insulating protective layer to quickly dissipate heat generated by the current of the wiring harness into the air, which is beneficial to decreasing the temperature of the wiring harness and reducing the fusing risk of the conductive trace.
(14) The device cost is low, which reduces the cost of the wiring harness.

### BRIEF DESCRIPTION OF THE DRAWINGS

The following drawings are only for schematic illustration and explanation of the present disclosure, rather than limiting the scope thereof. In which:
FIG. 1 illustrates a schematic diagram of a wiring harness production method according to the present disclosure;
FIGS. 2 and 3 illustrate partial schematic diagrams of a wiring harness produced by a wiring harness production method according to the present disclosure;
FIG. 4 illustrates a top view of an embodiment of a wiring harness produced by a wiring harness production method according to the present disclosure;
FIG. 5 illustrates a lateral cross-sectional view of an embodiment of a wiring harness produced by a wiring harness production method according to the present disclosure;
FIG. 6 illustrates a top view of another embodiment of a wiring harness produced by a wiring harness production method according to the present disclosure; and
FIG. 7 illustrates a lateral cross-sectional view of another embodiment of a wiring harness produced by a wiring harness production method according to the present disclosure.

### DESCRIPTION OF EMBODIMENTS

In order to have a clearer understanding of the technical features, objectives and effects of the present disclosure, specific embodiments of the present disclosure will be described below with reference to the drawings. In the description of the present disclosure, unless otherwise specified, 'a plurality of' means two or more.

### Embodiment 1

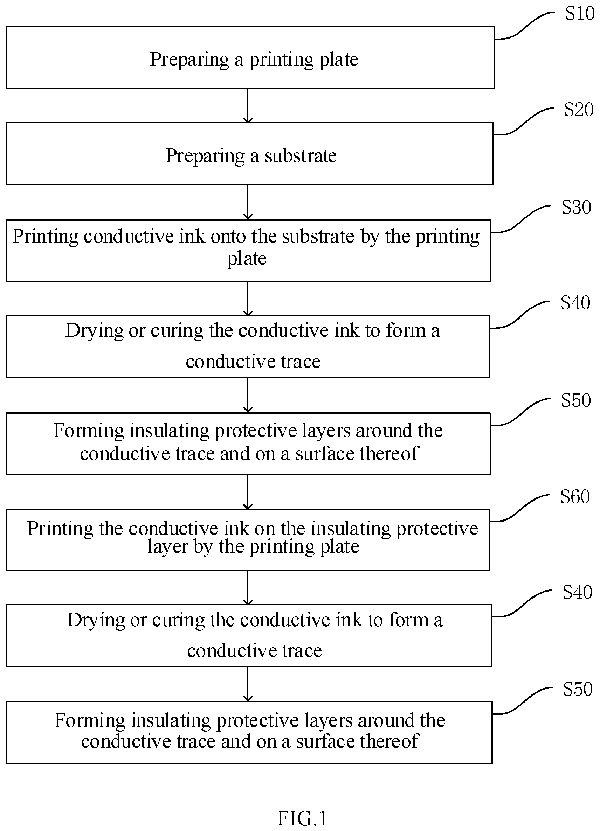

The present disclosure provides a wiring harness production method, as illustrated in FIG. 1, including: Step S10: preparing a printing plate; Step S20: preparing a substrate 10; Step S30: printing conductive ink onto the substrate 10 by the printing plate; Step S40: coagulating the conductive ink to form a conductive trace 21; and Step S50: forming an insulating protective layer 40 around the conductive trace 21 and on a surface thereof.

The wiring harness production method employs the mode of conductive ink printing to form the conductive trace 21 on the substrate 10, in which the conductive trace 21 may be connected to an external electrical component to realize the electrical connection function of the wiring harness; and performs an insulating protection by the insulating protective layer 40, thereby realizing the rapid formation of a wiring harness loop. By adopting the wiring harness production method, the conductive trace 21 has a high formation efficiency and can be formed at one time, thereby realizing automatic and large-batch rapid production with a high degree of production automation. The wiring harness composed of the parts such as electrical wires, terminals, sheaths, etc., is difficult to be mounted and assembled in its operational environment, which is a significant time-consuming step in the whole mounting and assembly process of the product. It is convenient to mount and dismount the wiring harness produced by this production method, thereby improving the assembly efficiency.

In an embodiment, the wiring harness production method includes Step S60 performed after Step S50, in which Step S60 includes printing the conductive ink onto the insulating protective layer 40 by the printing plate, and Step S60, Step S40 and Step S50 are alternately performed one or more times in sequence.

In Step S30 and Step S40, one conductive layer 30 is formed on the substrate 10; and when Step S60 and Step S40 are performed once, another conductive layer 30 may be formed on the formed conductive trace 21 and the insulating protective layer 40. By alternatively performing Step S60, Step S40 and Step S50, a plurality of conductive layers 30 are constructed on the substrate 10 to form a multi-layer structure. Multi-layer printing is adopted to form a plurality of conductive layers 30, so that more conductive traces 21 can be prepared under the condition of a small area of the substrate 10, thereby meeting the demand for more electrical loops.

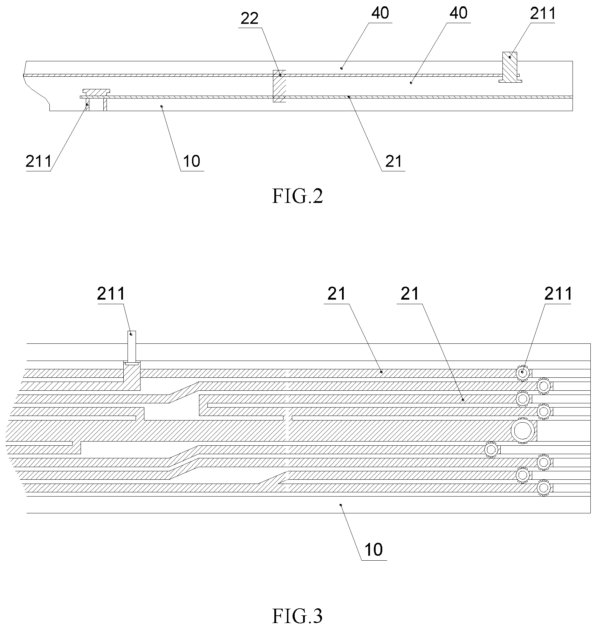

FIGS. 2 and 3 illustrate schematic diagrams of a wiring harness produced by a wiring harness production method, in which the wiring harness illustrated in FIG. 2 has a double-layer structure. As illustrated in FIG. 3, one conductive layer 30 may include a plurality of conductive traces 21. In a wiring harness with a multi-layer structure, each conductive layer 30 may have the same or different numbers and structures of the conductive traces 21.

Further, the wiring harness production method includes Step S70: punching a hole in the insulating protective layer 40 and/or the conductive trace 21, and pouring a conductive material to form a via 22 that electrically connects at least two layers of the conductive traces 21. By punching the hole and pouring the conductive material, it is possible to electrically connect the conductive traces 21 of different layers, and realize the design scheme of a complex electrical loop, which is applied to more complex wiring harnesses.

In an embodiment, the wiring harness produced by the wiring harness production method includes a plurality of conductive layers 30, and a hole is punched in the insulating protective layer 40 between two adjacent conductive layers 30 and filled with a conductive material to form the via 22, which communicates the conductive traces 21 of the two adjacent conductive layers 30.

In an embodiment, the wiring harness produced by the wiring harness production method includes at least three conductive layers 30, which include an upper conductive layer 31, a middle conductive layer 32 and a lower conductive layer 33; a via 22 passing through the middle conductive layer 32 is provided to be communicated with the upper conductive layer 31 and the lower conductive layer 33, respectively. In some cases, the via 22 passes through and is communicated with the conductive trace 21 of the middle conductive layer 32, so that the upper conductive layer 31, the middle conductive layer 32 and the lower conductive layer 33 are simultaneously communicated. In other cases, the via 22 passes through the middle conductive layer 32 via an area where the conductive trace 21 is not provided, communicates the upper conductive layer 31 with the lower conductive layer 33, and bypass the conductive trace 21 of the middle conductive layer 32 to avoid a communication therewith.

In some embodiments, one or more conductive layers 30 are provided between the two conductive layers 30 which are communicated with the via 22, and a communication with the intermediate one or more conductive layers 30 should be avoided. It is possible to improve the conductive trace 21 in the intermediate one or more conductive layer 30. For example, the conductive trace 21 extends along a curve or a polyline to avoid the position where the via 22 is disposed by hole punching. It is also possible to dispose the via 22 to extend along a polyline or a curve to avoid the intermediate one or more conductive layers 30.

The hole punching and the pouring of the conductive material may be performed after each of the conductive layers 30 is formed, or at the same time of forming the conductive layer 30 and the insulating protective layer 40. For example, after one conductive layer 30 or one insulating protective layer 40 is formed, a hole is punched therein and poured with the conductive material to form the via 22, and then the next conductive layer 30 or insulating protective layer 40 is continuously formed. In some cases, the conductive traces 21 in the intermediate conductive layers 30 are dense, and it is difficult for the via 22 to bypass the conductive traces 21 in the intermediate conductive layers 30 just by reconfiguring the conductive traces 21. Therefore, the inventor makes a further improvement to the wiring harness production method and the wiring harness produced thereby.

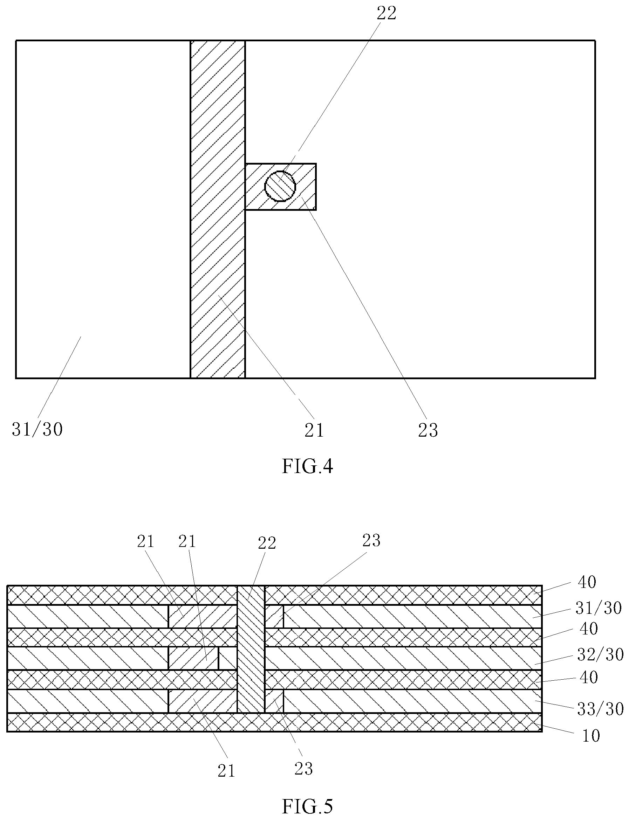

As illustrated in FIGS. 4 and 5, the wiring harness includes an upper conductive layer 31, a middle conductive layer 32 and a lower conductive layer 33; the conductive trace 21 in the upper conductive layer 31 is respectively connected to conductive protrusions 23, which are deviated from the conductive trace 21 in the middle conductive layer 32; and the via 22 is respectively communicated with the conductive protrusion 23 in the upper conductive layer 31 and the conductive protrusion 23 in the lower conductive layer 33, and bypasses the conductive trace 21 in the middle conductive layer 32, thereby communicating the upper conductive layer 31 with the lower conductive layer 33 and avoiding a communication with the middle conductive layer 32.

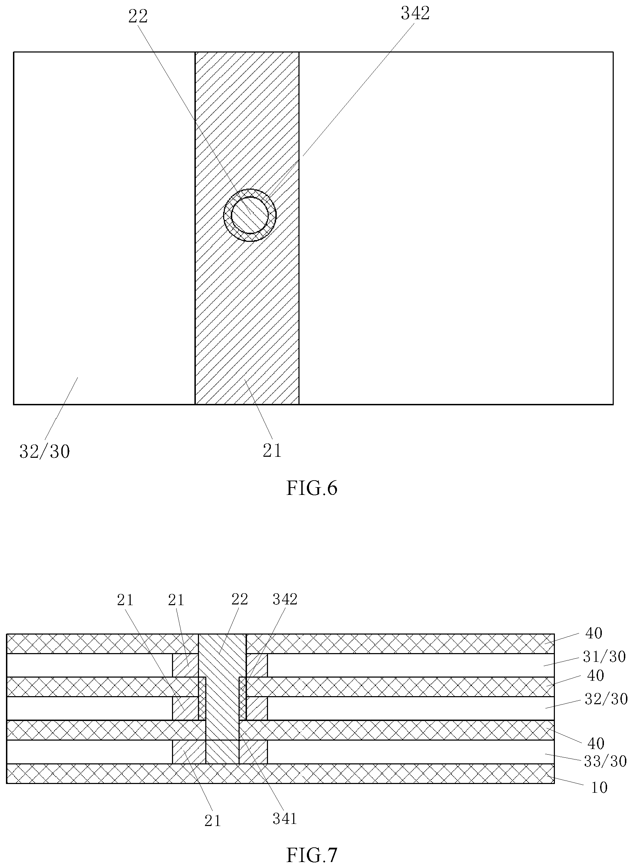

As illustrated in FIGS. 6 and 7, the wiring harness includes an upper conductive layer 31, a middle conductive layer 32 and a lower conductive layer 33; the hole punching position in Step S50 directly faces the conductive trace 21 of the upper conductive layer 31, the conductive trace 21 of the lower conductive layer 33 and the conductive trace 21 of the middle conductive layer 32; the punched hole passes through the conductive trace 21 of the middle conductive layer 32, and is provided with an insulating sleeve 34 which is located in the middle conductive layer 32 and isolates the conductive trace 21 of the middle conductive layer 32; and a conductive material is poured into the hole and the insulating sleeve 34, thereby avoiding a communication between the via 22 and the middle conductive layer 32.

Further, as illustrated in FIG. 7, the hole punched in Step S50 is a stepped hole, which has a part with a small inner diameter in the lower conductive layer 33 for the convenience of disposing the insulating sleeve 34, and a stepped part of the stepped hole can support the insulating sleeve 34.

In an embodiment, one conductive layer 30 formed in Steps S30 and S40 includes a plurality of conductive traces 21 to prepare more conductive traces 21. In the same conductive layer 30, the plurality of conductive traces 21 are disconnected from each other or electrically connected to each other. For example, the respective conductive traces 21 in the same conductive layer 30 are disconnected from each other. In the same conductive layer 30, at least two conductive traces 21 are electrically connected to each other. The conductive traces 21 in each of the conductive layers 30 are set according to the electrical connection function to be realized.

The structure of the conductive trace 21 in the conductive layer 30 is determined by the printing plate. The wiring harness production method adopts transfer printing, and the printing plate is designed according to the conductive trace 21 to be formed. The conductive ink is coated on the printing plate firstly, and then printed by a printing device. The printing plate is prepared in advance, and the conductive trace 21 in the conductive layer 30 is formed by printing, so that the plurality of conductive traces 21 can form a multi-circuit and complex electrical loop.

In an embodiment, the printing plate is processed and prepared by machining or 3D printing in Step S10. The printing plate is prepared according to the requirement of the electrical loop, an ink layer can be formed on the printing plate according to the path of the conductive trace, and the ink may be printed on the substrate 10 or the insulating protective layer 40 by transfer printing. As a cross-sectional width of the conductive trace 21 increases, the conducted current increases. The printing plate is designed according to the current to be conducted, so as to control the cross-sectional width of the conductive trace 21.

The conductive trace 21 has a convex shape and a large cross-sectional area. In an embodiment, multiple printing is adopted in step S30, and the thickness of the conductive trace 21 is increased by multiple printing in the same conductive layer 30. The same printing plate may be used for multiple printing, so as to gradually increase the thickness of the conductive trace 21.

In an embodiment, Step S30 adopts screen printing, relief printing, flexographic printing, intaglio printing or flat printing. In intaglio printing, the thickness of the printing ink may be controlled through adjusting recesses depth of the printing plate, and the conductive traces 21 with different thicknesses can be provided in the same conductive layer 30 by specially designing the printing plate for intaglio printing.

Specifically, in the case of screen printing, a screen-printing plate with a graphic part is prepared by taking a screen as a plate base and using a photosensitive platemaking method. The device of screen printing includes a screen-printing plate, a scraper, ink, a printing table, and a printing stock that may be the substrate 10 or the formed insulating protective layer 40. Printing is carried out using a basic principle that a mesh of the graphic part of the screen-printing plate is permeable to ink and a mesh of a non-graphic part is impermeable to ink. In the case of relief printing, the graphic part of the printing plate is convex. In the case of flexographic printing, a molded rubber relief plate is used for printing. In the case of intaglio printing, the whole surface of the printing plate is coated with ink, and then the ink on the blank part is cleaned by a special ink scraping mechanism, so that the ink only remains in the mesh of the graphic part, and then the ink is transferred to the surface of the printing stock under a high pressure, in which the printing stock may be the substrate 10 or the formed insulating protective layer 40. In the case of flat printing, the graphic part and the non-graphic part on the printing plate are substantially located on a same plane, and during printing, in order to distinguish the graphic part and the non-graphic part for the ink, the non-graphic part of the printing plate is supplied with water by a water supply device of the printing plate component, so as to be protected from being wetted by the ink.

The wiring harness produced by the wiring harness production method may be a planar wiring harness or a spatial wiring harness, in which the planar wiring harness is two-dimensional, and the conductive trace 21 extends in a planar manner along axes X and Y; and the spatial wiring harness is three-dimensional, and the conductive trace 21 may extend in a direction of axis Z in addition to direction of the axes X and Y. In a case where the produced wiring harness is a planar wiring harness, screen printing, relief printing, flexographic printing, intaglio printing or flat printing is adopted in Step S30. In a case where the produced wiring harness is a spatial wiring harness, relief printing, flexographic printing or intaglio printing is exemplarily adopted in Step S30.

The same printing process may be adopted in Step S60 as in Step S30, which will not be described here.

In Step S40, the conductive ink may be coagulated by drying. In an embodiment, In Step S40, one or more of natural drying, cold and hot air drying, infrared radiation drying and ultraviolet curing to dry are adopted and coagulate the conductive ink.

In an embodiment, in Step S50, one or more processes of coating, printing, spraying, immersion plating and injection molding are adopted to form the insulating protective layer 40, so as to ensure the insulating protective effect of the insulating protective layer 40 on the conductive layer 30.

Step S20 includes cleaning the surface of the substrate 10. The cleaning mode of the substrate 10 may be one or more of solution washing and cleaning, ultrasonic cleaning and high-pressure washing to remove oil stains, impurities and dirt.

In an embodiment, the wiring harness production method further includes Step S15 performed after Step S10, in which Step S15 includes: providing an insulating layer on the surface of the substrate 10, and forming the conductive trace 21 on a surface of the insulating layer. When the substrate 10 is made of a conductive material, the insulation between the conductive traces 21 can be ensured by providing an insulating layer on the substrate 10 in advance. The insulating layer may be formed by one or more processes of coating, printing, spraying, immersion plating and injection molding. When the substrate 10 is made of an insulating material, the insulating layer may not be provided.

The substrate 10 may adopt a profile modeling structure and printing may be performed on a non-planar substrate 10, thereby extending the application environment of the produced wiring harness, so as to facilitate the adaptation of the produced wiring harness to the application environment. The substrate 10 may adopt a flexible substrate 10, so that the produced wiring harness can be suitable for various mounting situations and convenient to be applied to electrical components in complex mounting environments, which is beneficial to reducing the interference of vibration factors and ensuring the stability of use in environments with high vibration requirements. The substrate 10 may be a constituent part of an electrical components, and can realize the integrated production of the components and the wiring harness, thereby achieving the rapid mounting and dismounting of the wiring harness. For example, the substrate 10 is a component of a vehicle body or a vehicle-mounted electrical components, and the conductive trace 21 is integrated with the substrate 10, so that the wiring harness can be replaced by replacing the substrate 10, which not only saves the maintenance man-hours, but also reduces the maintenance cost. For example, an inner lining plate of a vehicle door may be used as the substrate 10 of a door wiring harness, and the inner lining plate can be directly replaced during maintenance. The substrate 10 may also be a component of a body in white, a bumper, a roof, an inner door panel, a seat frame or any vehicle-mounted electrical components.

According to the wiring harness production method, the conductive trace 21 is formed by printing, so that the cost of the device is low, the cost of the wiring harness is reduced, the processing is rapid, the additive processing is realized, and the pollution is small. The printing plate may be processed by machining and 3D printing. The conductive ink is printed using a printing device. The wiring harness production method does not require the raw material of the electrical wiring or complicated processes such as wiring cutting, terminal pressing, sheath insertion, encapsulation, etc., and the wires may be printed at one time or directly on the housing of a corresponding product, thereby saving the processing time and realizing large-batch automatic production.

In an embodiment, the wiring harness production method includes Step S25 and Step S80, in which Step S25 is performed before Step S30 and Step S80 is performed after Step S50; Step S25 includes printing a lower shielding layer on the substrate, and Step S80 includes printing an upper shielding layer on the periphery of the insulating protective layer, in which the upper shielding layer and the lower shielding layer are electrically connected to enclose the conductive trace. The upper shielding layer and the lower shielding layer are connected through a shielding layer on a sidewall of the wiring harness, so that the upper shielding layer, the lower shielding layer and the shielding layer on the sidewall of the wiring harness form a box structure to surround the conductive trace. A shielding structure is provided outside the wiring harness, so that a signal in the wiring harness can be shielded from electromagnetic interference at a position with strong electromagnetic interference, thereby ensuring the stability of the signal.

In a case where the wiring harness includes a plurality of conductive layers, the upper shielding layer is provided above the uppermost conductive layer, that is, Step S80 is performed before Step S50 which is performed last time. Under the condition that the surface of the substrate is provided with an insulating layer, the lower shielding layer is provided above the insulating layer. The shielding layer on the sidewall of the wiring harness may be formed by spraying or printing, or formed of an aluminum foil.

In an embodiment, the wiring harness production method further includes Step S90 performed after Step S50, in which Step S90 includes crimping or welding connecting terminals 211 at a tail end of the conductive trace, and by mutual plugging between the connecting terminals 211, achieving electrical connection between different wiring harnesses or between a wiring harness and an electrical component.

As illustrated in FIGS. 2 and 3, the tail end of the conductive trace 21 is provided with a connecting terminal 211, which may be a connecting finger, a pin terminal or a welding electrical wire, so as to be connected to any other electrical loop.

Further, the wiring harness production method further includes Step S100 performed after Step S90, in which Step S100 includes providing sheaths at the tail end of the conductive trace, and accommodate the connecting terminals 211 in the sheaths, so as to achieve the contact connection between the connecting terminals in the sheaths through butting between the sheaths. In some cases, a plurality of connecting terminals 211 are provided in one sheath, and two matched sheaths are connected to ensure the firmness of connection, so that the electrical connection between the connecting terminals 211 is more reliable and stable.

In an embodiment, the wiring harness production method further includes Step S110 performed after Step S50, in which Step S110 includes providing heat sink on the insulating protective layer, and quickly dissipating the heat generated by the current of the wiring harness into the air through the heat sink, which is beneficial to decreasing the temperature of the wiring harness and reducing the fusing risk of the conductive trace.

### Embodiment 2

The present disclosure provides a wiring harness, which is produced by the wiring harness production method, the wiring harness including: a substrate 10, at least one conductive trace 21 and at least one insulating protective layer 40, in which each conductive trace 21 is located between the substrate 10 and the outermost insulating protective layer 40, and the conductive trace 21 and the insulating protective layer 40 are alternately distributed. The wiring harness is suitable for automatic and large-batch rapid production, and the conductive trace 21 may be formed at one time, so that the degree of production automation is high, the efficiency is high, and the production cost is reduced, thereby facilitating mounting and dismounting and improving the assembly efficiency.

In an embodiment, the conductive trace has a cross-sectional width of 0.1 mm to 68 mm. In the wiring harness, the cross-sectional area of the conductor determines the current that the conductor can conduct. In general, the conductor that realizes signal conduction has small current, so the cross-sectional area thereof is small. For example, a minimum cross-sectional area of a signal line in a vehicle wiring harness may be 0.1 mm². But the conductor that realizes power conduction has large current, so the cross-sectional area thereof is large. For example, a maximum cross-sectional area of the wiring harness for a vehicle battery reaches 260 mm².

When the width of the conductive trace 21 is less than 0.1 mm, in order to obtain a conductor with a cross-sectional area of 0.1 mm², it is necessary to print the conductive trace 21 with a thickness of at least 1 mm. Since the thickness increases as the width decreases, in order to obtain a large thickness, it is necessary to perform printing for multiple times, which wastes the man-hours and reduces the processing efficiency. In addition, the conductive trace 21 is too narrow, the strength cannot meet the requirement, and the layout of the wiring harness is restricted, so that the height of the wiring harness cannot be reduced.

When the width of the conductive trace 21 is greater than 68 mm, in order to obtain a conductor with a cross-sectional area of 260 mm², it is necessary to print a conductor with a thickness of at least 3.82 mm. As the width decreases, the thickness increases, but the area of the printed conductive trace 21 also increases and the occupied area of the wiring harness cannot be reduced.

Therefore, the inventor chooses the cross-sectional width of the conductive trace to be 0.1 mm to 68 mm, and the conductors with different cross-sectional areas can be obtained by printing the conductive traces 21 with different thicknesses.

Through multiple experiments, the inventor acquires that when the cross-sectional width of the conductive trace is 0.5 mm to 58 mm, an aspect ratio of the printed conductive trace 21 is within a reasonable range, and the thickness range is suitable for printing and processing, while the occupied area will not be wasted. Therefore, the inventor exemplarily chooses the cross-sectional width of the conductive trace to be 0.5 mm to 58 mm.

In an embodiment, the conductive trace is made of conductive ink. The conductive ink can achieve a conductive performance and is sticky to be firmly attached to the base material, and it has fluidity so that the conductive trace can be manufactured by a printing process, so that the degree of production automation is high, the efficiency is high, and the production cost is reduced.

In an embodiment, the conductive ink includes conductive filler, adhesive, solvent and additive, in which the conductive filler includes one or combinations of metallic powder, conductive ceramic, carbon-containing conductor, solid electrolyte, mixed conductor and conductive polymer material.

In an embodiment, the carbon-containing conductor is one or combinations of graphite powder, carbon nanotube material and graphene material.

The conductive ink may be prepared using metallic powder or other conductive powder, so that the formed conductive trace 21 have good conductivity while being simple and convenient to prepare with little pollution.

In an embodiment, the metallic powder may be one or more of nickel or alloy thereof, cadmium or alloy thereof, zirconium or alloy thereof, chromium or alloy thereof, cobalt or alloy thereof, manganese or alloy thereof, aluminum or alloy thereof, tin or alloy thereof, titanium or alloy thereof, zinc or alloy thereof, copper or alloy thereof, silver or alloy thereof, and gold or alloy thereof. Exemplarily, the most commonly used metal material for the conductor is copper or copper alloy, because the conductivity of copper is good among metals, and copper is not a precious metal while being convenient for processing and good in ductility. However, with the increasing price of copper, the material cost of the conductor made of copper is higher and higher. To this end, people begin to look for alternatives to copper to reduce the cost. The content of metallic aluminum in the earth's crust is about 7.73%, and after the optimization of the refining technology, the price thereof is relatively low. In addition, compared with copper, aluminum is lighter, and its conductivity is second only to copper, so that aluminum or aluminum alloy can partially replace copper or copper alloy in the field of electrical connections.

In an embodiment, the adhesive includes at least one from a group of epoxy resin, polyester resin, acrylic resin, polyamide resin, modified phenolic resin and cellulose resin.

In an embodiment, the insulating protective layer is made of one or combinations of polyvinyl chloride, polyurethane, nylon, polypropylene, silicone rubber, crosslinked polyolefin, synthetic rubber, polyurethane elastomer, crosslinked polyethylene and polyethylene.

In an embodiment, the insulating protective layer has a breakdown strength of 0.3 KV/mm to 35 KV/mm. The breakdown strength is also called a dielectric breakdown strength, which refers to a highest electric field strength that a material can withstand without being damaged (broken down) in an electric field. When the breakdown strength of the insulating protective layer is lower than 0.3 KV/mm, a thin part of the insulating protective layer may be broken down under a normal voltage, resulting in invalid insulation. When the breakdown strength of the insulating protective layer is higher than 35 KV/mm, the choice of a material with too high breakdown strength will increase the cost of an integrated wiring harness assembly and cause design waste, because a high voltage greater than 35 KV will not occur in the general vehicle-mounted environment.

In an embodiment, the insulating protective layer has a thickness of 0.03 mm to 5 mm. If the thickness of the insulating protective layer is less than 0.03 mm, not only the breakdown voltage of the insulating protective layer cannot be ensured to be higher than the working voltage, but also the wear resistance of the insulating protective layer cannot be guaranteed. After repeated scraping and grinding, the insulating protective layer may be damaged to expose the conductor, which leads to a current leakage or a short circuit, resulting in a line damage and a functional failure. When the thickness of the insulating protective layer is 5 mm, the breakdown voltage, the insulation resistance and the wear resistance of the insulating protective layer can meet the requirements. However, if the thickness is greater than 5 mm, there may be defects such as air holes and collapse during processing due to the large thickness of the insulating protective layer, which degrades the performance and wastes the material of the insulating protective layer, and increases the processing procedures and time. Therefore, the inventor chooses the thickness of the insulating protective layer as 0.03 mm to 5 mm.

The substrate 10 may adopt a profile modeling structure and printing may be performed on a non-planar substrate 10, thereby extending the application environment of the produced wiring harness, so as to facilitate the adaptation of the produced wiring harness to the application environment. The substrate 10 may adopt a flexible substrate 10, so that the produced wiring harness can be suitable for various mounting situations and convenient to be applied to electrical components in complex mounting environments, which is beneficial to reducing the interference of vibration factors and ensuring the stability of use in environments with high vibration requirements. The substrate 10 may be a constituent part of an electrical components, and can realize the integrated production of the components and the wiring harness, thereby achieving the rapid mounting and dismounting of the wiring harness. For example, the substrate 10 is a component of a vehicle body or a vehicle-mounted electrical components, and the conductive trace 21 is integrated with the substrate 10, so that the wiring harness can be replaced by replacing the substrate 10, which not only saves the maintenance man-hours, but also reduces the maintenance cost. For example, an inner lining plate of a vehicle door may be used as the substrate 10 of a door wiring harness, and the inner lining plate can be directly replaced during maintenance. The substrate 10 may also be a component of a body in white, a bumper, a roof, an inner door panel, a seat frame or any vehicle-mounted appliance.

Generally, the printed circuit board mainly serves as a circuit board to mount electrical components and realize specific electrical functions. The wiring harness is different from the conventional printed circuit board in that the wiring harness serves to conduct current and transmit signals. The tail end of the conductive trace 21 is provided with a connecting terminal 211, which may be a connecting finger, a pin terminal, a welding electrical wire or the like so as to connect the conductive trace 21 with a power source or an electrical component.

At present, the vehicle wiring harness is generally produced separately by a wiring harness factory, where electrical wires, terminals, sheaths, positioning pieces, seals, brackets, etc. are processed and assemble together to form a complete wire harness, and then delivered to a vehicle factory, where the wiring harness is assembled to the vehicle body depending on the working station during final assembly, so the mounting is difficult and labor is wasted.

The wiring harness may be directly mounted on a sheet metal of the vehicle body, an instrument panel or an electrical component without being disposed separately, and the mounting of the wiring harness can be completed once the mounting of vehicle components is completed, thereby saving the man-hours of the final assembly of the vehicle and reducing the manual operations by at least 60%.

## Claims

1. A method for producing a wiring harness, comprising:
a first step (S10): preparing a printing plate;
a second step (S20): preparing a substrate (10);
a third step (S30): printing a conductive ink that has been prepared using metallic or conductive powder onto the substrate (10) by the printing plate;
a fourth step (S40): drying or curing the conductive ink to form a conductive trace (21); and
a fifth step (S50): forming an insulating protective layer (40) around the conductive trace (21) and on a surface thereof;
a sixth step (S60): printing the conductive ink onto the insulating protective layer (40) by the printing plate; wherein the sixth step (S60) is performed after the fifth step (S50), and the sixth step (S60), the fourth step (S40) and the fifth step (S50) are alternately performed one or more times in sequence,
thereby obtaining a multilayer stack consisting of a substrate (10) and at least two conductive traces (21) with protective layers (40) placed in between and on top of the conductive traces (21);
**characterized in that**
the method further comprises:
a seventh step (S70): punching a hole in the insulating protective layers (40) and the conductive traces (21), and pouring a conductive material to form a via (22) that electrically connects at least two layers of the conductive traces (21).

2. The method according to claim 1, further comprising:
Step S25: printing a lower shielding layer on the substrate (10);
Step S80: printing an upper shielding layer on the periphery of the insulating protective layer (40), wherein the upper shielding layer and the lower shielding layer are electrically connected to enclose the conductive trace (21); and
Step S25 is performed before the third step (S30), and Step S80 is performed before the fifth step (S50).

3. The method according to claim 1, wherein in the third step (S30) multiple printing is used.

4. The method according to claim 1, wherein in the third step (S30) screen printing, relief printing, flexographic printing, intaglio printing or flat printing is used.

5. The method according to claim 4, wherein the wiring harness is a spatial wiring harness, and in the third step (S30) relief printing, flexographic printing or intaglio printing is used.

6. The method according to claim 1, further comprising Step S90 performed after the fifth step (S50), wherein Step S90 comprises crimping or welding connecting terminals (211) at a tail end of the conductive trace (21).

7. The method according to claim 6, further comprising Step S100 performed after Step S90, wherein Step S100 comprises providing sheaths at the tail end of the conductive trace (21), and accommodating the connecting terminals (211) in the sheaths.

8. The method according to claim 1, further comprising Step S110 performed after the fifth step (S50), wherein Step S110 comprises providing a heat sink on the insulating protective layer (40).

9. The method according to claim 1, wherein in the fourth step (S40), one or more of natural drying, cold and hot air drying, infrared radiation drying and ultraviolet curing to dry are used and coagulate the conductive ink; or
one conductive layer formed in the third step (S30) and the fourth step (S40) comprises a plurality of the conductive traces (21) which are disconnected from or electrically connected to each other in the same conductive layer; or
in the first step (S10), machining or 3D printing is used to processing and manufacturing the printing plate; or
the wiring harness production method, further comprising Step S15 performed after the first step (S10), wherein Step S15 comprises providing an insulating layer on a surface of the substrate (10); or
in the fifth step (S50), one or more processes of coating, printing, spraying, immersion plating and injection molding are used to form the insulating protective layer (40).

10. A wiring harness, which is produced by the method according to any of claims 1 to 9, the wiring harness comprising: a substrate (10), at least one conductive trace (21) and at least one insulating protective layer (40), wherein each conductive trace (21) is located between the substrate (10) and an outermost insulating protective layer (40), and the conductive trace (21) and the insulating protective layer (40) are alternately distributed.

11. The wiring harness according to claim 10, wherein the conductive trace (21) has a cross-sectional width of 0.1 mm to 68 mm; further
the conductive trace (21) has a cross-sectional width of 0.5 mm to 58 mm.

12. The wiring harness according to claim 10, wherein the conductive trace (21) is made of conductive ink.

13. The wiring harness according to claim 12, wherein the conductive ink comprises conductive filler, adhesive, solvent and additive, and the conductive filler comprises one or combinations of metallic powder, conductive ceramic, carbon-containing conductor, solid electrolyte, mixed conductor and conductive polymer material; and
the carbon-containing conductor is one or combinations of graphite powder, carbon nanotube material and graphene material; and
the metallic powder is one or more selected from the group consisting of nickel or alloy thereof, cadmium or alloy thereof, zirconium or alloy thereof, chromium or alloy thereof, cobalt or alloy thereof, manganese or alloy thereof, aluminum or alloy thereof, tin or alloy thereof, titanium or alloy thereof, zinc or alloy thereof, copper or alloy thereof, silver or alloy thereof, and gold or alloy thereof.

14. The wiring harness according to claim 10, wherein the insulating protective layer (40) is made of one or combinations of polyvinyl chloride, polyurethane, nylon, polypropylene, silicone rubber, crosslinked polyolefin, synthetic rubber, polyurethane elastomer, crosslinked polyethylene and polyethylene; or
the insulating protective layer (40) has a breakdown strength of 0.3 KV/mm to 35 KV/mm; or
the insulating protective layer (40) has a thickness of 0.03mm to 5 mm.

## Patentansprüche

1. Verfahren zur Herstellung eines Kabelbaums, aufweisend:
einen ersten Schritt (S10): Vorbereiten einer Druckplatte;
einen zweiten Schritt (S20): Vorbereiten eines Substrats (10);
einen dritten Schritt (S30): Aufdrucken einer leitfähigen Tinte, die unter Verwendung von Metall- oder leitfähigem Pulver hergestellt wurde, auf das Substrat (10) mittels der Druckplatte;
einen vierten Schritt (S40): Trocknen oder Aushärten der leitfähigen Tinte, um eine leitfähige Leiterbahn (21) zu bilden; und
einen fünften Schritt (S50): Bilden einer isolierenden Schutzschicht (40) um die leitfähige Leiterbahn (21) herum und auf einer Oberfläche derselben;
einen sechsten Schritt (S60): Drucken der leitfähigen Tinte auf die isolierende Schutzschicht (40) mittels der Druckplatte; wobei der sechste Schritt (S60) nach dem fünften Schritt (S50) durchgeführt wird und der sechste Schritt (S60), der vierte Schritt (S40) und der fünfte Schritt (S50) abwechselnd ein- oder mehrmals nacheinander durchgeführt werden,
wodurch ein mehrschichtiger Stapel erhalten wird, der aus einem Substrat (10) und mindestens zwei Leiterbahnen (21) besteht, wobei Schutzschichten (40) zwischen und auf den Leiterbahnen (21) angeordnet sind;
**dadurch gekennzeichnet, dass**
das Verfahren des Weiteren aufweist:
einen siebten Schritt (S70): Stanzen eines Lochs in die isolierenden Schutzschichten (40) und die leitfähigen Leiterbahnen (21) sowie Eingießen eines leitfähigen Materials, um eine Durchkontaktierung (22) zu bilden, die mindestens zwei Schichten der leitfähigen Leiterbahnen (21) elektrisch verbindet.

2. Verfahren nach Anspruch 1, des Weiteren aufweisend:
Schritt S25: Aufbringen einer unteren Abschirmschicht auf das Substrat (10);
Schritt S80: Aufbringen einer oberen Abschirmschicht auf den Randbereich der isolierenden Schutzschicht (40), wobei die obere Abschirmschicht und die untere Abschirmschicht elektrisch verbunden sind, um die leitfähige Leiterbahn (21) zu umschließen; und
wobei Schritt S25 vor dem dritten Schritt (S30) und Schritt S80 vor dem fünften Schritt (S50) durchgeführt werden.

3. Verfahren nach Anspruch 1, bei dem im dritten Schritt (S30) Mehrfachdruck verwendet wird.

4. Verfahren nach Anspruch 1, bei dem im dritten Schritt (S30) Siebdruck, Hochdruck, Flexodruck, Tiefdruck oder Flachdruck verwendet wird.

5. Verfahren nach Anspruch 4, bei dem der Kabelbaum ein räumlicher Kabelbaum ist und im dritten Schritt (S30) Hochdruck, Flexodruck oder Tiefdruck verwendet wird.

6. Verfahren nach Anspruch 1, das ferner den nach dem fünften Schritt (S50) durchgeführten Schritt S90 aufweist, wobei der Schritt S90 das Crimpen oder Schweißen von Anschlussklemmen (211) an einem hinteren Ende der Leiterbahn (21) aufweist.

7. Verfahren nach Anspruch 6, das ferner den nach dem Schritt S90 durchgeführten Schritt S100 aufweist, wobei Schritt S100 das Anbringen von Hüllen am hinteren Ende der Leiterbahn (21) und das Aufnehmen der Anschlussklemmen (211) in den Hüllen aufweist.

8. Verfahren nach Anspruch 1, das ferner den nach dem fünften Schritt (S50) durchgeführten Schritt S110 aufweist, wobei Schritt S110 das Anbringen eines Kühlkörpers auf der isolierenden Schutzschicht (40) aufweist.

9. Verfahren nach Anspruch 1, bei dem im vierten Schritt (S40) eine oder mehrere der folgenden Methoden zum Trocknen verwendet werden: natürliche Trocknung, Kalt- und Heißlufttrocknung, Trocknung durch Infrarotstrahlung und Aushärtung durch Ultraviolettstrahlung, um die leitfähige Tinte zu koagulieren; oder
eine im dritten Schritt (S30) und im vierten Schritt (S40) gebildete leitfähige Schicht eine Vielzahl von leitfähigen Leiterbahnen (21) aufweist, die innerhalb derselben leitfähigen Schicht voneinander getrennt oder elektrisch miteinander verbunden sind; oder
im ersten Schritt (S10) die Druckplatte mittels Bearbeitung oder 3D-Druck verarbeitet und hergestellt wird; oder
das Verfahren zur Herstellung eines Kabelbaums ferner den nach dem ersten Schritt (S10) durchgeführten Schritt S15 aufweist, wobei der Schritt S15 das Aufbringen einer Isolierschicht auf eine Oberfläche des Substrats (10) aufweist; oder
im fünften Schritt (S50) ein oder mehrere Verfahren des Beschichtens, Druckens, Sprühens, Tauchbeschichtens und Spritzgießens verwendet werden, um die isolierende Schutzschicht (40) zu bilden.

10. Kabelbaum, der nach dem Verfahren gemäß einem der Ansprüche 1 bis 9 hergestellt wird, wobei der Kabelbaum aufweist: ein Substrat (10), mindestens eine Leiterbahn (21) und mindestens eine isolierende Schutzschicht (40), wobei sich jede Leiterbahn (21) zwischen dem Substrat (10) und einer äußersten isolierenden Schutzschicht (40) befindet und die Leiterbahn (21) und die isolierende Schutzschicht (40) abwechselnd angeordnet sind.

11. Kabelbaum nach Anspruch 10, bei dem die Leiterbahn (21) eine Querschnittsbreite von 0,1 mm bis 68 mm aufweist; ferner
die leitfähige Leiterbahn (21) eine Querschnittsbreite von 0,5 mm bis 58 mm aufweist.

12. Kabelbaum nach Anspruch 10, bei dem die leitfähige Leiterbahn (21) aus leitfähiger Tinte besteht.

13. Kabelbaum nach Anspruch 12, bei dem die leitfähige Tinte einen leitfähigen Füllstoff, ein Bindemittel, ein Lösungsmittel und ein Additiv aufweist, und der leitfähige Füllstoff ein oder eine Kombination aus Metallpulver, leitfähiger Keramik, einem kohlenstoffhaltigen Leiter, einem Festelektrolyten, einem Mischleiter und einem leitfähigen Polymermaterial aufweist; und
der kohlenstoffhaltige Leiter ein oder eine Kombination aus Graphitpulver, Kohlenstoffnanoröhrenmaterial und Graphenmaterial ist; und
das Metallpulver eines oder mehrere aus der Gruppe bestehend aus Nickel oder einer Legierung davon, Cadmium oder einer Legierung davon, Zirkonium oder einer Legierung davon, Chrom oder einer Legierung davon, Kobalt oder einer Legierung davon, Mangan oder einer Legierung davon, Aluminium oder einer Legierung davon, Zinn oder einer Legierung davon, Titan oder einer Legierung davon, Zink oder einer Legierung davon, Kupfer oder einer Legierung davon, Silber oder einer Legierung davon und Gold oder einer Legierung davon ist.

14. Kabelbaum nach Anspruch 10, bei dem die isolierende Schutzschicht (40) aus einem oder einer Kombination von Polyvinylchlorid, Polyurethan, Nylon, Polypropylen, Silikonkautschuk, vernetztem Polyolefin, synthetischem Kautschuk, Polyurethan-Elastomer, vernetztem Polyethylen und Polyethylen besteht; oder
die isolierende Schutzschicht (40) eine Durchschlagfestigkeit von 0,3 kV/mm bis 35 kV/mm aufweist; oder
die isolierende Schutzschicht (40) eine Dicke von 0,03 mm bis 5 mm aufweist.

## Revendications

1. Procédé de production d'un faisceau de câbles, comprenant:
une première étape (S10): préparation d'une plaque d'impression;
une deuxième étape (S20): préparation d'un substrat (10);
une troisième étape (S30): impression d'une encre conductrice, préparée à partir de poudre métallique ou conductrice, sur le substrat (10) à l'aide de la plaque d'impression;
une quatrième étape (S40): séchage ou durcissement de l'encre conductrice pour former une piste conductrice (21); et
une cinquième étape (S50): formation d'une couche protectrice isolante (40) autour de la piste conductrice (21) et sur une surface de celle-ci;
une sixième étape (S60): impression de l'encre conductrice sur la couche protectrice isolante (40) à l'aide de la plaque d'impression; la sixième étape (S60) étant réalisée après la cinquième étape (S50) et la sixième étape (S60), la quatrième étape (S40) et la cinquième étape (S50) étant réalisées alternativement une ou plusieurs fois de suite,
ce qui permet d'obtenir un empilement multicouche composé d'un substrat (10) et d'au moins deux pistes conductrices (21), des couches protectrices (40) étant disposées entre et sur les pistes conductrices (21);
**caractérisé en ce que**
le procédé comprend en outre:
une septième étape (S70): le poinçonnage d'un trou dans les couches protectrices isolantes (40) et les pistes conductrices (21), ainsi que le coulage d'un matériau conducteur pour former une interconnexion (22) qui relie électriquement au moins deux couches des pistes conductrices (21).

2. Procédé selon la revendication 1, comprenant en outre:
l'étape S25: application d'une couche de blindage inférieure sur le substrat (10);
étape S80: application d'une couche de blindage supérieure sur la zone périphérique de la couche protectrice isolante (40), la couche de blindage supérieure et la couche de blindage inférieure étant reliées électriquement afin d'envelopper la piste conductrice (21); et
dans lequel l'étape S25 est réalisée avant la troisième étape (S30) et l'étape S80 est réalisée avant la cinquième étape (S50).

3. Procédé selon la revendication 1, dans lequel on utilise l'impression multiple dans la troisième étape (S30).

4. Procédé selon la revendication 1, dans lequel, lors de la troisième étape (S30), on utilise la sérigraphie, l'impression en relief, la flexographie, l'héliogravure ou l'impression à plat.

5. Procédé selon la revendication 4, dans lequel le faisceau de câbles est un faisceau de câbles spatial et dans lequel, lors de la troisième étape (S30), on utilise la typographie, la flexographie ou l'héliogravure.

6. Procédé selon la revendication 1, comprenant en outre l'étape S90 effectuée après la cinquième étape (S50), l'étape S90 comprenant le sertissage ou le soudage de bornes de connexion (211) à une extrémité arrière de la piste conductrice (21).

7. Procédé selon la revendication 6, comprenant en outre l'étape S100 effectuée après l'étape S90, l'étape S100 comprenant la fixation de gaines à l'extrémité arrière de la piste conductrice (21) et l'insertion des bornes de connexion (211) dans les gaines.

8. Procédé selon la revendication 1, comprenant en outre l'étape S110 effectuée après la cinquième étape (S50), l'étape S110 comprenant la fixation d'un dissipateur thermique sur la couche protectrice isolante (40).

9. Procédé selon la revendication 1, dans lequel, à la quatrième étape (S40), on utilise une ou plusieurs des méthodes de séchage suivantes: séchage naturel, séchage à l'air froid et à l'air chaud, séchage par rayonnement infrarouge et durcissement par rayonnement ultraviolet, afin de coaguler l'encre conductrice; ou
une couche conductrice formée lors de la troisième étape (S30) et de la quatrième étape (S40) comporte une pluralité de pistes conductrices (21) qui sont séparées les unes des autres ou reliées électriquement entre elles à l'intérieur de cette même couche conductrice; ou
dans la première étape (S10), la plaque d'impression est traitée et fabriquée par usinage ou impression 3D; ou
le procédé de fabrication d'un faisceau de câbles comprend en outre l'étape S15 effectuée après la première étape (S10), l'étape S15 comprenant l'application d'une couche isolante sur une surface du substrat (10); ou
à la cinquième étape (S50), on utilise un ou plusieurs procédés parmi le revêtement, l'impression, la pulvérisation, le revêtement par immersion et le moulage par injection pour former la couche protectrice isolante (40).

10. Faisceau de câbles fabriqué selon le procédé selon l'une des revendications 1 à 9, le faisceau de câbles comprenant: un substrat (10), au moins une piste conductrice (21) et au moins une couche protectrice isolante (40), chaque piste conductrice (21) étant située entre le substrat (10) et une couche protectrice isolante (40) la plus externe, et la piste conductrice (21) et la couche protectrice isolante (40) étant disposées en alternance.

11. Faisceau de câbles selon la revendication 10, dans lequel la piste conductrice (21) présente une largeur de section transversale comprise entre 0,1 mm et 68 mm; en outre
la piste conductrice (21) présente une largeur de section transversale comprise entre 0,5 mm et 58 mm.

12. Faisceau de câbles selon la revendication 10, dans lequel la piste conductrice (21) est constituée d'encre conductrice.

13. Faisceau de câbles selon la revendication 12, dans lequel l'encre conductrice comprend une charge conductrice, un liant, un solvant et un additif, et la charge conductrice comprend une ou une combinaison de poudre métallique, de céramique conductrice, d'un conducteur carboné, d'un électrolyte solide, d'un conducteur mixte et d'un matériau polymère conducteur; et
le conducteur carboné est constitué d'une ou d'une combinaison de poudre de graphite, de nanotubes de carbone et de graphène; et
la poudre métallique est un ou plusieurs éléments choisis dans le groupe constitué du nickel ou d'un alliage de celui-ci, du cadmium ou d'un alliage de celui-ci, du zirconium ou d'un alliage de celui-ci, du chrome ou d'un alliage de celui-ci, du cobalt ou d'un alliage de celui-ci, du manganèse ou d'un alliage de celui-ci, de l'aluminium ou d'un alliage de celui-ci, de l'étain ou d'un alliage de celui-ci, du titane ou un alliage de celui-ci, du zinc ou un alliage de celui-ci, du cuivre ou un alliage de celui-ci, de l'argent ou un alliage de celui-ci et de l'or ou un alliage de celui-ci.

14. Faisceau de câbles selon la revendication 10, dans lequel la couche protectrice isolante (40) est constituée d'un ou d'une combinaison de chlorure de polyvinyle, de polyuréthane, de nylon, de polypropylène, de caoutchouc silicone, de polyoléfine réticulée, de caoutchouc synthétique, d'élastomère de polyuréthane, de polyéthylène réticulé et de polyéthylène; ou
la couche protectrice isolante (40) présente une rigidité diélectrique comprise entre 0,3 kV/mm et 35 kV/mm ; ou
la couche protectrice isolante (40) présente une épaisseur comprise entre 0,03 mm et 5 mm.
